# EUROPÄISCHE PATENTANMELDUNG

(11) **EP 2 869 416 A2**
(43) Veröffentlichungstag der Anmeldung: **06.05.2015**
(21) Anmeldenummer: 14161913.0
(22) Anmeldetag: 27.03.2014
(51) Int. Cl.: H02G 3/04

(54) **Kabelschutzrohr**

(30) Priorität: 29.10.2013 DE 202013104832 U
(71) Anmelder: REHAU AG + Co, 95111 Rehau (DE)
(72) Erfinder: Kania, Guido, 91080 Marloffstein (DE); Winterling, Ralf, 91074 Herzogenaurach (DE)

(57) **Zusammenfassung**

Die Erfindung betrifft ein Kabelschutzrohr (1) für die Aufnahme wenigstens eines Höchstspannungskabels (5), das eine Wandung (1.1) aufweist, die ein Polymermaterial enthält, das sich dadurch auszeichnet, dass in der Wandung (1.1) ein weichmagnetisches Material (2) enthalten ist.

## Beschreibung

Die Erfindung betrifft ein Kabelschutzrohr für die Aufnahme eines Höchstspannungskabels. Weiterhin betrifft die Erfindung ein Kabelschutzrohrsystem und eine Stromleitungsanordnung, die ein solches Kabelschutzrohr oder Kabelschutzrohrsystem nutzt.

Der Ausbau der erneuerbaren Energien schreitet stark voran, so dass insbesondere die dezentral in sogenannten Offshore- und Onshore-Windparkanlagen, mithilfe von Wasserkraftanlagen, mithilfe der Photovoltaik und der Biogasnutzung erzeugte elektrische Energie den Verbrauchern zuzuleiten ist. Vermehrt wird dabei neben den bekannten Höchstspannungsfreileitungen auf die Anordnung von Höchstspannungskabeln unter der Erde gesetzt. Bei derartigen Höchstspannungskabeln liegen Spannungen von mehr als 100 kV, meist 380 kV vor. Daher sind entsprechende Vorkehrungen zu treffen, um von diesen Kabeln ausgehende Effekte physikalischer Natur zu beherrschen.

Einerseits bildet sich um stromdurchflossene Kabel ein Magnetfeld, das entsprechend abzuschirmen ist, andererseits wird im Kabel durch den Stromfluss Wärme erzeugt, die abzuführen ist.

Die Effekte sind groß und durch die hohe Stromstärke bedingt, die durch die Kabel fließt. Hierbei ist ein wesentlicher Punkt, dass sich um das stromdurchflossene Höchstspannungskabel bildende Magnetfeld möglichst effektiv abzuschirmen. Dies gelingt bereits teilweise dadurch, dass solche Höchstspannungskabel entweder paarweise oder bei einer sogenannten Drehstromanordnung als drei etwa parallel verlaufende Höchstspannungskabel angeordnet sind. Durch diese Anordnung wird das sich bildende Magnetfeld durch gegenseitige Kompensation - hervorgerufen durch die Überlagerung der Magnetfelder in den Höchstspannungskabeln - bereits sehr deutlich verringert. Dennoch kann es notwendig sein, weitere Abschirmmaßnahmen zu ergreifen, um das Restmagnetfeld unter die nach den einschlägigen Verordnungen genehmigten Grenzwerte bzw. projektspezifischen Anforderungen zu bringen.

Hier setzt die Erfindung ein, die es sich zur Aufgabe gemacht hat, ein Kabelschutzrohr für die Aufnahme eines Höchstspannungskabels anzugeben, mit dem einfach und effektiv ein Schutz des Höchstspannungskabels, eine hohe Abschirmung des sich um stromdurchflossene Höchstspannungskabel bildende Magnetfeldes und eine Abführung der entstehenden Wärme erreichen lässt.

Eine weitere Aufgabe der vorliegenden Erfindung ist es, ein Kabelschutzrohrsystem und eine Stromleitungsanordnung anzugeben, die ein derartiges Kabelschutzrohr oder Kabelschutzrohrsystem nutzt, um darin wenigstens ein Höchstspannungskabel anzuordnen.

Erfindungsgemäß wird die Aufgabe, ein Kabelschutzrohr für die Aufnahme wenigstens eines Höchstspannungskabels anzugeben, durch die im kennzeichnenden Teil des Anspruchs 1 angegebenen Merkmale gelöst.

Weitere vorteilhafte Ausgestaltungen der Erfindung sind in den Unteransprüchen angegeben.

Die vorliegende Aufgabe wird gelöst durch ein Kabelschutzrohr für die Aufnahme eines Höchstspannungskabels gemäß Anspruch 1, um das sich um das stromdurchflossene Höchstspannungskabel bildende Magnetfeld wenigstens teilweise abzuschirmen und um das Höchstspannungskabel effektiv zu schützen.

Das Kabelschutzrohr für die Aufnahme wenigstens eines Höchstspannungskabels gemäß vorliegender Erfindung weist eine Wandung auf, die ein Polymermaterial enthält und zeichnet sich dadurch aus, dass in der Wandung ein weichmagnetisches Material enthalten ist. Mit einem derartigen erfindungsgemäßen Kabelschutzrohr gelingt es in einfacher und effektiver Weise, das sich um stromdurchflossene Höchstspannungskabel bildende Magnetfeld wenigstens teilweise abzuschirmen. Die Abschirmung erfolgt durch das in der Wandung des Kabelschutzrohres enthaltene weichmagnetische Material.

Im vorliegenden Erfindungszusammenhang wird unter Abschirmung, beispielsweise unter der Bezeichnung "wenigstens teilweise abzuschirmen" und ebenso anderer vergleichbarer Bezeichnungen eine Abschirmung, also Verminderung des Magnetfeldes verstanden. Dies kann anhand von sogenannten "Abschirmfaktoren" quantifiziert werden.

Bei einem Abschirmfaktor von 2 ist das ursprünglich vorhandene Magnetfeld durch die Abschirmung auf die Hälfte reduziert, entsprechend bei einem Abschirmfaktor von 10 auf ein Zehntel.

Im vorliegenden Erfindungszusammenhang wird zugrunde gelegt, dass sich die Werte auf die magnetische Feldstärke um stromdurchflossene Höchstspannungskabel und gleichermaßen stromdurchflossene Höchstspannungskabel, welche in dem Kabelschutzrohr gemäß vorliegender Erfindung angeordnet sind, beziehen.

Durch die Erfindung ist es möglich, Abschirmfaktoren von 2 bis 100 zu realisieren, also das ursprünglich vorhandene Magnetfeld auf die Hälfte bis auf ein Hundertstel zu reduzieren.

In einer bevorzugten Ausführungsform der vorliegenden Erfindung hat sich als sehr vorteilhaft herausgestellt, wenn das Kabelschutzrohr derartig gebildet ist, dass das weichmagnetische Material eine magnetische Permeabilitätszahl µr von > 500 aufweist.

Ein weichmagnetisches Material mit einer magnetischen Permeabilitätszahl µr von > 500 ist in ganz besonders guter Weise dafür geeignet, Magnetfelder, die sich um stromdurchflossene Höchstspannungskabel bilden, möglichst effektiv abzuschirmen. Im vorliegenden Erfindungszusammenhang hat sich als äußerst günstig herausgestellt, wenn das weichmagnetische Material Eisen oder eine Eisen-Silizium-Legierung oder eine Eisen-Nickel-Legierung oder ein µ-Metall oder eine Mischung der vorgenannten ist.

Mit einem weichmagnetischen Material aus Eisen oder einer Eisen-Silizium-Legierung oder einer Eisen-Nickel-Legierung oder einem µ-Metall oder einer Mischung der vorgenannten gelingt es in ganz besonders günstiger Weise, das sich um stromdurchflossene Höchstspannungskabel bildende Magnetfeld wenigstens teilweise abzuschirmen.

In einer sehr nützlichen Fortbildung der vorliegenden Erfindung kann vorgesehen sein, dass das weichmagnetische Material als Partikel oder als Filament oder als Draht oder als Band oder als Folie ausgebildet ist. Die weichmagnetischen Materialien gemäß obiger Aufzählung lassen sich in einfacher Weise zu Partikeln oder Filamenten oder Drähten oder Bänder oder Folien ausbilden. Hierzu sind vergleichsweise einfache Verfahrensschritte bekannt. Weichmagnetische Materialien als Partikel oder als Draht oder als Band oder als Folie lassen sich für die Abschirmung von Magnetfeldern sehr effektiv nutzen.

Durch die Wahl des weichmagnetischen Materials, dessen Form als Partikel oder als Filament oder als Draht oder als Band oder als Folie, dessen Anteil in der Wandung des Kabelschutzrohres sowie der Anordnung in der Wandung des Kabelschutzrohres gelingt es in einfacher Weise, das Kabelschutzrohr derartig magnetfeldabschirmend zu gestalten, dass dieses eine maximale Wirksamkeit im Hinblick auf die Abschirmung magnetischer Felder, die von Höchstspannungskabeln ausgehen, aufweist.

Durch das Kabelschutzrohr für die Aufnahme eines Höchstspannungskabels gemäß vorliegender Erfindung, das eine Wandung aufweist, die ein Polymermaterial enthält und sich dadurch auszeichnet, dass in der Wandung ein weichmagnetisches Material enthalten ist, wird auch die Aufgabe gelöst, die Wärme, die im stromdurchflossenen Leiter entsteht, abzuführen.

Mit einem weichmagnetischen Material aus Eisen oder einer Eisen-Silizium-Legierung oder einer Eisen-Nickel-Legierung oder einem µ-Metall oder einer Mischung der vorgenannten gelingt es in ganz besonders günstiger Weise, die durch den Stromfluss im Höchstspannungskabel bildende Wärme effektiv an den umgebenden Erdboden abzuführen.

Die oben genannten Materialien leiten die Wärme ausreichend gut, so dass durch die Wandung des Kabelschutzrohres hindurch ein Wärmetransport erfolgen kann.

Das Kabelschutzrohr der vorliegenden Erfindung kann in einer weiteren Ausführungsform derart ausgebildet sein, dass das Polymermaterial aus einem Thermoplasten ausgewählt ist, insbesondere einem Polyolefin, bevorzugt einem Polypropylen (PP) oder einem Polyethylen (PE) oder einem vernetzten Polyethylen (PE-X) oder einem Polybutylen (PB), oder einem Polyvinylchlorid (PVC), oder einem Copolymer, einem Blend oder einer Mischung der vorgenannten.

Mit der Auswahl eines Polymermaterials aus den vorgenannten Materialien gelingt es in einfacher Weise, ein sehr dauerhaftes Kabelschutzrohr, das beispielsweise durch einen Rohrextrusionsvorgang kostengünstig und in großer Länge herstellbar ist, zur Verfügung zu stellen.

Kabelschutzrohre aus den genannten Polymermaterialien sind langlebig, verrottungssicher, korrodieren nicht, sind fluiddicht und verhalten sich im Boden inert.

Mit besonderem Vorteil kann im Rahmen einer Fortbildung der vorliegenden Erfindung vorgesehen sein, dass das Kabelschutzrohr eine mehrschichtig aufgebaute Wandung aufweist. Durch das Vorsehen einer mehrschichtig aufgebauten Wandung kann das Kabelschutzrohr an gewisse technische Randbedingungen in einfacher Weise angepasst werden.

Hierzu kann insbesondere vorgesehen sein, dass die innerste Schicht der Wandung eine Gleitschicht und / oder als äußerste Schicht der mehrschichtigen Wandung eine Schutzschicht angeordnet ist.

Durch das Vorsehen einer Gleitschicht als innerste Schicht der Wandung gelingt es in sehr einfacher Weise, ein bzw. mehrere Höchstspannungskabel in das Kabelschutzrohr einzubringen, in dem beim Einbringen des Höchstspannungskabels nur eine geringe Gleitreibung an der inneren Wandung des Kabelschutzrohres vorliegt.

Hierdurch können insbesondere große Längen eines Höchstspannungskabels in einfacher Weise in ein Kabelschutzrohr der vorliegenden Erfindung eingebracht werden. Eine Schutzschicht als äußerste Schicht der mehrschichtigen Wandung des Kabelschutzrohres ist insbesondere von Vorteil, wenn das Kabelschutzrohr beispielsweise maschinell in den Boden eingebracht wird, in dem dieses beispielsweise eingepflügt wird.

Eine Schutzschicht als äußerte Schicht der mehrschichtigen Wandung des Kabelschutzrohres verhindert dabei, dass beim Einbringen in den Boden Beschädigungen des Kabelschutzrohres erfolgen.

Die äußerste Schicht kann aber auch so modifiziert sein, dass mit dieser die Wärmeübertragung an das das Kabelschutzrohr umgebende Bettungsmaterial optimiert ist.

Es hat sich im Rahmen der vorliegenden Erfindung als sehr praktikabel erwiesen, wenn vorgesehen ist, dass ein Kabelschutzrohr mit wenigstens einem weiteren Kabelschutzrohr durch eine Kabelschutzrohrverbindungsmuffe verbindbar ist. Auf diese Weise lassen sich in einfacher Art eine Vielzahl von Kabelschutzrohren durch solche Kabelschutzrohrverbindungsmuffen untereinander verbinden. Sehr vorteilhaft ist die Kabelschutzrohrverbindungsmuffe so gestaltet, dass sich diese Kabelschutzrohre miteinander fluiddicht verbinden.

Auch kann in einer sehr bevorzugten Fortbildung der Erfindung vorgesehen sein, dass die Kabelschutzrohrverbindungsmuffe sehr lang ausgebildet ist, um eine unerwünschte Abwinklung im Bereich der Stoßstellen der zu verbindenden Kabelschutzrohre weitgehend zu vermeiden.

Dazu kann die Kabelschutzrohrverbindungsmuffe etwa 1,2- bis 3-fach, insbesondere 1,5-fach so lang ausgebildet sein, wie ihr innerer Durchmesser beträgt.

Sehr vorteilhaft lässt sich eine Kabelschutzrohrverbindungsmuffe nutzen, deren Wandung die in gleicher Weise ausgebildet ist, wie vorstehend beim Kabelschutzrohr beschrieben.

Eine derartige Kabelschutzrohrverbindungsmuffe kann in einfacher und effektiver Weise das sich um die stromdurchflossenen Höchstspannungskabel bildende Magnetfeld wenigstens teilweise abzuschirmen. Die Abschirmung erfolgt durch das in der Wandung der Kabelschutzrohrverbindungsmuffe enthaltene weichmagnetische Material.

Die Erfindung betrifft auch ein Kabelschutzrohrsystem, welches wenigstens ein Kabelschutzrohr wie vorstehend beschrieben umfasst, welches mit einer Kabelschutzrohrverbindungsmuffe verbunden ist.

Die Verbindung des Kabelschutzrohres und der Kabelschutzrohrverbindungsmuffe zum Kabelschutzrohrsystem erfolgt dabei bevorzugterweise fluiddicht. Hierzu kann das Kabelschutzrohr und die Kabelschutzrohrverbindungsmuffe durch einen Steckvorgang, durch einen Schweißvorgang oder durch einen Klebevorgang oder durch eine Kombination der vorstehend genannten Vorgänge verbunden sein.

Die weitere Aufgabe der vorliegenden Erfindung, ein Kabelschutzrohrsystem anzugeben, erfährt ihre Lösung in Anspruch 9.

Hierzu wird das Kabelschutzrohrsystem, umfassend wenigstens ein Kabelschutzrohr, wie vorstehend beschrieben und einer mit dem wenigstens einen Kabelschutzrohr verbundenen Kabelschutzrohrverbindungsmuffe, zur Verfügung gestellt.

Schließlich erfährt die weitere Aufgabe der vorliegenden Erfindung, eine Stromleitungsanordnung anzugeben, ihre Lösung in Anspruch 10.

Hierzu umfasst die Stromleitungsanordnung der vorliegenden Erfindung wenigstens ein Höchstspannungskabel und ein Kabelschutzrohr, wie vorstehend beschrieben, oder ein Kabelschutzrohrsystem gemäß vorstehender Beschreibung, wobei das Höchstspannungskabel in dem Kabelschutzrohr oder Kabelschutzrohrsystem aufgenommen ist.

Diese Stromleitungsanordnung, welche wenigstens ein Höchstspannungskabel umfasst, weist einen hohen Abschirmfaktor auf bezogen auf das vom Höchstspannungskabel ausgehende Magnetfeld.

Im Rahmen der vorliegenden Erfindung wurde erkannt, dass eine Stromleitungsanordnung, umfassend wenigstens ein Höchstspannungskabel, dann besonders effektiv ist hinsichtlich der Abschirmung des vom Höchstspannungskabel ausgehenden Magnetfeldes, wenn das Höchstspannungskabel in einem Kabelschutzrohr oder Kabelschutzrohrsystem gemäß vorliegender Erfindung aufgenommen ist.

Solche Stromleitungsanordnungen sind in bevorzugter Weise unter der Erdoberfläche eingebaut. Durch das erfindungsgemäße Kabelschutzrohr bzw. Kabelschutzrohrsystem ist das von dem wenigstens einen Höchstspannungskabel ausgehende Magnetfeld weitgehend abgeschirmt.

In einer sehr günstigen Weiterbildung der vorliegenden Erfindung kann vorgesehen sein, dass in einem Graben im Erdboden der Raum um das Kabelschutzrohr bzw. Kabelschutzrohrsystem ein Verfüllmaterial, das Beton oder thermisch leitfähiger Beton oder ein thermisch stabilisierter Boden oder eine Mischung der vorgenannten ist, enthält.

Durch diese Maßnahme kann in besonders effektiver Weise Wärmeenergie, die beim Betrieb eines Höchstspannungskabels unweigerlich freigesetzt wird, an das umgebende Erdboden abgeführt werden.

Bei der vorliegenden Erfindung hat es sich als sehr vorteilhaft erwiesen, wenn folgendes Verfahren zum Einbau einer Stromleitungsanordnung unter der Erdoberfläche angewandt wird:

Im ersten Schritt ist ein Graben auszuheben, der etwas tiefer und breiter herzustellen ist als die Anordnung an Kabelschutzrohren mit Höchstspannungskabeln, die in diesen Graben unter der Erdoberfläche zu verlegen sind. Im Garben wird mit Verfüllmaterial ein Planum hergestellt, auf dem die Anordnung an Kabelschutzrohren mit Höchstspannungskabeln zu verlegen ist.

In diesen Graben mit der dort platzierten Anordnung ist ein Verfüllmaterial, beispielsweise Beton oder thermisch leitfähiger Beton oder ein thermisch stabilisierter Boden oder ein Flüssigboden oder eine Mischung der vorgenannten, einzubringen.

Bei der Einbringung von Flüssigboden ist dafür Sorge zu tragen, dass das Kabelschutzrohr, in welches auch erst später das Höchstspannungskabel eingezogen werden kann, nicht durch Auftriebskräfte unerwünscht seine Lage verändert. Hierzu können geeignete Anker - wie beispielsweise Erdnägel - oder eine Auflast, beispielsweise in Form eines konturangepassten Betonbauteils eingesetzt werden, die dem Auftrieb entgegenwirken und die Lage des Kabelschutzrohres im Graben fixieren.

Nachdem diese Anordnung etwas verfestigt ist, wozu beispielsweise ein Verdichtungsgerät einsetzbar ist bzw. im Falle eines eingebrachten Flüssigbodens nach einer gewissen Verfestigungszeit, kann durch Verfüllen des restlichen freien Raumes beispielsweise mit dem Aushub des Erdbodens bei der Herstellung des Grabens wieder das Niveau der Erdoberfläche hergestellt werden.

Daran anschließend können dann die Höchstspannungskabel in das Kabelschutzrohr eingezogen werden.

Auf diese Weise kann mit vergleichsweise einfachen Tiefbautechniken unter Verwendung des Kabelschutzrohres der vorliegenden Erfindung eine Stromleitungsanordnung schnell und kostengünstig hergestellt werden, die hinsichtlich der Abschirmung des sich beim Betrieb bildenden Magnetfelds optimiert ist.

Die Trasse der Stromleitungsanordnung kann dann in geeigneter Weise markiert werden, beispielsweise durch das Aufstellen von Markierungselementen, hierzu können Pfeiler oder Fahnen genutzt werden.

Weitere wichtige Merkmale und Vorteile der Erfindung ergeben sich aus den Unteransprüchen, aus den Fig. und aus der zugehörigen Figurenbeschreibung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Fig. dargestellt und werden in der nachfolgenden Beschreibung näher erläutert, wobei sich gleiche Bezugszeichen auf gleiche oder funktional gleiche oder ähnliche Bauteile beziehen.

Die Erfindung wird anhand der beigefügten Figuren wie folgt näher erläutert.

Hierzu zeigt:
- Fig. 1: eine schematische perspektivische Ansicht eines Kabelschutzrohres, die teilweise geschnitten ist;
- Fig. 2: eine schematische Querschnittsansicht eines Kabelschzrohrsystems aus zwei Kabelschutzrohren, die durch eine Kabelschutzrohrverbindungsmuffe miteinander verbunden sind;
- Fig. 3: eine schematische Querschnittsansicht einer Stromeitungsanordnung aus zwei Kabelschutzrohren, die durch eine Kabelschutzrohrverbindungsmuffe miteinander verbunden sind, wobei ein Höchstspannungskabel darin aufgenommen ist;
- Fig. 4: eine schematische Querschnittsansicht eines Erdbodens;
- Fig. 5: eine schematische Querschnittsansicht eines Grabens im Erdboden;
- Fig. 6: eine schematische Querschnittsansicht eines Grabens im Erdboden, in dem ein Planum hergestellt ist;
- Fig. 7: eine schematische Querschnittsansicht einer Stromleitungsanordnung, die in einem Graben im Erdboden, der verfüllt ist, eingebaut ist.

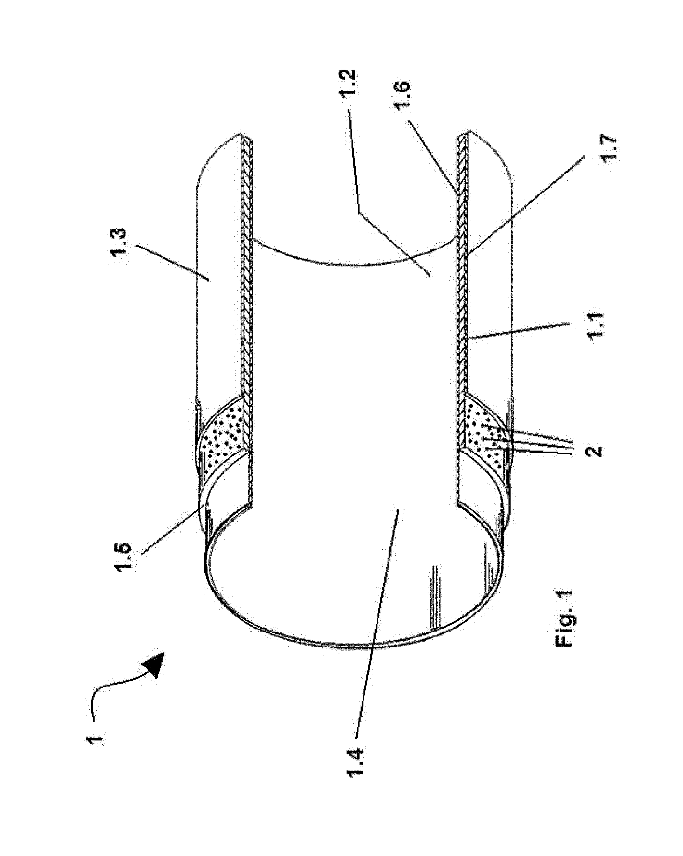

In Fig. 1 ist in einer schematischen perspektivischen Ansicht ein Kabelschutzrohr 1 der vorliegenden Erfindung gezeigt, das teilweise geschnitten ist.
Das Kabelschutzrohr 1 der vorliegenden Erfindung weist eine Wandung 1.1 auf. Die Wandung 1.1 des Kabelschutzrohres 1 begrenzt das Lumen 1.4. Die Wandung 1.1 des Kabelschutzrohres 1 weist eine Innenoberfläche 1.2 und eine Außenoberfläche 1.3 auf.
Die Wandung 1.1 des Kabelschutzrohres 1 weist eine Schicht 1.5 auf, in der ein weichmagnetisches Material 2 enthalten ist. Im vorliegenden Fall ist das weichmagnetische Material 2 in Form von Partikeln in der Schicht 1.5 homogen verteilt. In anderen hier nicht dargestellten Ausführungsarten der vorliegenden Erfindung kann auch vorgesehen sein, dass das weichmagnetische Material 2 in Form von Filamenten, Drähten, Bändern oder Folien oder in einer Kombination der vorstehenden in der Wandung 1.1 des Kabelschutzrohres 1 angeordnet ist. So kann zum Beispiel vorgesehen sein, dass ein Band auf der Schicht 1.5 des Kabelschutzrohres 1 aus weichmagnetischem Material 2 angeordnet ist, das mit einer weiteren Schicht aus Polymermaterial zum Schutz dieses weichmagnetischen Materials 2 bedeckt ist. Eine bevorzugte Ausführungsform der vorliegenden Erfindung kann sein, dass das weichmagnetische Material 2 in Form von Filamenten oder Drähten vorliegt, wobei das weichmagnetische Material 2 dann als Umflechtung die Schicht 1.5 der Wandung 1.1 des Kabelschutzrohres 1 bildet oder auf der Schicht 1.5 angeordnet ist.
In einer Weiterbildung der vorliegenden Erfindung kann auch - ohne dass es hier gezeigt ist - eine Anordnung des weichmagnetischen Materials 2 in Abschnitten, in Zonen oder in bestimmten Bereichen des Kabelschutzrohres 1 vorliegen.

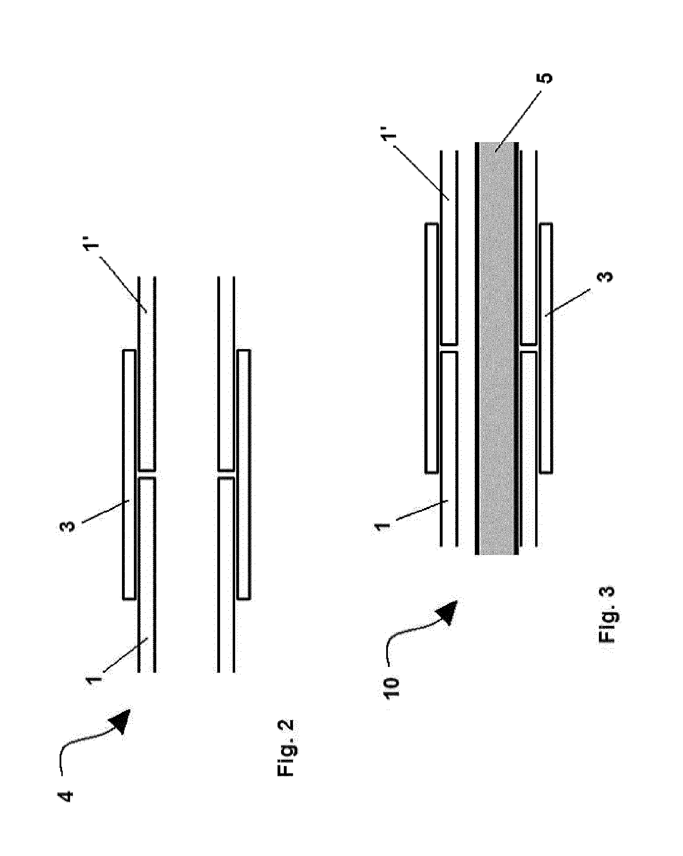

In Fig. 2 ist in einer schematischen Querschnittsansicht ein Kabelschutzrohrsystem 4 gemäß vorliegender Erfindung gezeigt.
Das Kabelschutzrohrsystem 4 umfasst zwei Kabelschutzrohre 1, 1', die durch eine Kabelschutzrohrverbindungsmuffe 3 fluiddicht miteinander verbunden sind.

Die Verbindung der Kabelschutzrohre 1, 1' mithilfe der Kabelschutzrohrverbindungsmuffe 3 kann dabei durch eine Stecktechnik, durch eine Schweißtechnik oder durch eine Klebetechnik oder durch eine Kombination der vorstehend genannten Techniken erfolgen.
Mit großem Vorteil ist die Länge der Kabelschutzrohrverbindungsmuffe 3 im Vergleich zu diesem Durchmesser so gewählt, dass diese 1,2- bis 3-mal, insbesondere 1,5-mal so lang ist, wie ihr innerer Durchmesser beträgt. Auf diese Weise wird der Verbindungsstoß der beiden Kabelschutzrohre 1, 1' besonders gut geschützt. Weiterhin ist die Verbindung der Kabelschutzrohre 1, 1' gegenüber unerwünschter Abwinkelung hinreichend stabilisiert.

In Fig. 3 ist in einer schematischen Querschnittsansicht eine Stromleitungsanordnung 10 gezeigt, die das Kabelschutzrohrsystem 4 gemäß Fig. 2 nutzt.
Dazu ist im Lumen der miteinander verbundenen Kabelschutzrohre 1, 1' des Kabelschutzrohrsystems 4 gemäß Fig. 2 ein Höchstspannungskabel 5 angeordnet.

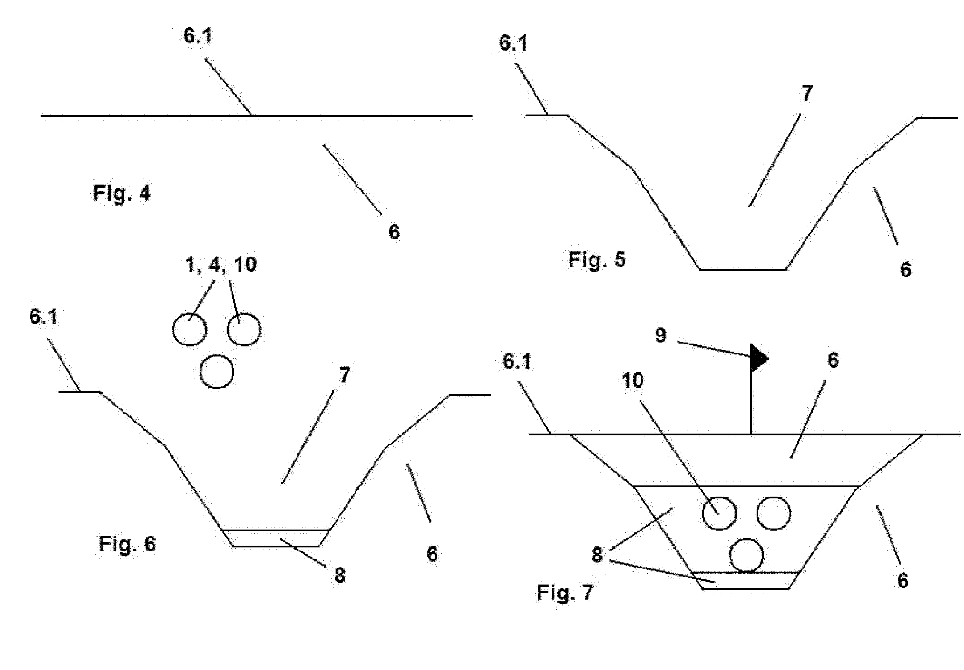

In Fig. 4 ist schematisch in einer Querschnittsansicht der Erdboden 6 und die Erdoberfläche 6.1 dargestellt.
Die Erdoberfläche 6.1 begrenzt die Ausdehnung des Erdbodens 6 nach oben, also entgegen der Schwerkraft.

In Fig. 5 ist in einer schematischen Querschnittsansicht ein Graben 7 gezeigt, der durch Ausheben von Erdboden 6 nach Durchbrechen der Erdoberfläche 6.1 hergestellt ist.
Der Graben 7 ist gemäß Abb. 5 mit etwa trapezförmigen Querschnitt ausgebildet und kann in einfacher Weise beispielsweise mittels eines Baggers erzeugt werden.
Die Ausdehnung des Grabens 7 hinsichtlich Tiefe, Breite und Länge richtet sich nach den Erfordernissen und technischen Vorgaben, darin eine Stromleitungsanordnung 10 einzubauen. Insbesondere kann der Graben 7 in einer anderen Ausbildung auch einen etwa rechteckigen Querschnitt aufweisen.

In Fig. 6 ist in einer schematischen Querschnittsansicht der Graben 7 gezeigt, an dessen Grund ein Planum aus Verfüllmaterial 8 hergestellt ist.
Abseits des Grabes 7 sind weiterhin drei Kabelschutzrohre 1 bzw. Kabelschutzrohrsysteme 4 bzw. Stromleitungsanordnungen 10 positioniert, wobei diese zueinander etwa gleich beabstandet sind. Die drei Kabelschutzrohre 1 bzw. Kabelschutzrohrsysteme 4 bzw. Stromleitungsanordnungen 10 sind dabei in Form etwa eines gleichseitigen Dreiecks angeordnet. Bei der Stromleitungsanordnung 10 ist im Lumen des Kabelschutzrohres 1 bzw. des Kabelschutzrohrsystems 4 wenigstens ein Höchstspannungskabel 5 angeordnet.

Zum Einbau der Kabelschutzrohre 1 bzw. Kabelschutzrohrsysteme 4 bzw. Stromleitungsanordnungen 10 im Graben 7 sind diese zunächst auf dem Planum des Verfüllmaterials 8 am Grund des Grabens 7 zu positionieren.
Der Freiraum zwischen und um den Kabelschutzrohren 1 bzw. Kabelschutzrohrsystemen 4 bzw. Stromleitungsanordnungen 10 im Graben 7 ist mit einem Verfüllmaterial 8, beispielsweise einem Beton oder einem thermisch leitfähigen Beton oder einem thermisch stabilisierten Boden aufzufüllen. Die Auffüllung ist dabei derartig vorzunehmen, dass Verfüllmaterial 8 in einer bestimmten Höhe über dem / den zu oberst liegenden Kabelschutzrohr 1 bzw. Kabelschutzrohrsystem 4 bzw. Stromleitungsanordnung 10 zum Liegen kommt, so dass diese geschützt und eingebettet sind.
Bei der Einbringung eines Verfüllmaterials 8 in Form von Flüssigboden ist dafür Sorge zu tragen, dass das Kabelschutzrohr 1 bzw. Kabelschutzrohrsystem 4 bzw. die Stromleitungsanordnung 10 nicht durch Auftriebskräfte unerwünscht eine Lageänderung erfährt. Hierzu können geeignete Anker - wie beispielsweise Erdnägel - oder eine Auflast, beispielsweise in Form eines konturangepassten Betonbauteils eingesetzt werden, die dem Auftrieb entgegenwirken und die Lage des Kabelschutzrohres 1 bzw. Kabelschutzrohrsystems 4 bzw. der Stromleitungsanordnung 10 im Graben 7 fixieren.
Vorteilhafterweise wird das Verfüllmaterial 8 verdichtet, wozu beispielsweise ein Verdichtungsgerät heranziehbar ist. Mithilfe des Verdichtungsgeräts ist es einfach, das Verfüllmaterial 8 im Graben 7 etwa so zu verdichten, dass eine horizontale Abschlussfläche nach oben hergestellt und ein guter Kontakt des Verfüllmaterials 8 zu den Kabelschutzrohren 1 bzw. den Kabelschutzrohrsystemen 4 bzw. den Stromleitungsanordnungen 10 ohne Spaltbildung erzielt wird. Dadurch sind diese fest im Verfüllmaterial 8 eingebettet und die Ableitung von Wärme kann effektiv in den Erdboden 6 erfolgen. Alternativ kann das Verfüllmaterial 8 auch als Flüssigboden selbstverdichtend eingebracht werden, wobei dann eine Auftriebssicherung vorzusehen ist.

In Fig. 7 ist abschließend ein schematischer Querschnitt einer Stromleitungsanordnung 10 gezeigt.
Diese ist in einem verfüllten Graben 7 angeordnet.
Sie umfasst drei Kabelschutzrohre 1 bzw. Kabelschutzrohrsysteme 4, in denen Höchstspannungskabel 5 aufgenommen sind.

Diese sind gegenseitig etwa gleich beabstandet. Die drei Kabelschutzrohre 1 bzw. Kabelschutzrohrsysteme 4 sind dabei in Form etwa eines gleichseitigen Dreiecks angeordnet.
Die Höchstspannungskabel 5 sind dabei beabstandet, um die Wärmeenergie, die beim Stromfluss durch die Höchstspannungskabel 5 entsteht, gleichmäßig zu verteilen, ohne dass dabei ein "hot spot" mit unerwünscht hohen Temperaturen entsteht, und an den umgebenden Erdboden 6 abzuführen. Durch die Nutzung der erfindungsgemäßen Kabelschutzrohre 1 bzw. Kabelschutzrohrsysteme 4 gemäß vorliegender Erfindung sind die Höchstspannungskabel 5 einerseits geschützt, anderseits wird das beim Stromfluss gebildete Magnetfeld abgeschirmt.
Der vorher bestehende Graben 7 ist mit Erdboden 6 wieder aufgefüllt und verdichtet, so dass die ursprünglich vorhandene Erdoberfläche 6.1 in etwa wieder hergestellt ist.
Die Trasse der Stromleitungsanordnung 10 ist durch ein Markierungselement 9, im vorliegenden Fall beispielsweise eine Fahne, gekennzeichnet.

### Bezugszeichenliste

- 1: Kabelschutzrohr
- 1': weiteres Kabelschutzrohr
- 1.1: Wandung
- 1.2: Innenoberfläche
- 1.3: Außenoberfläche
- 1.4: Lumen
- 1.5: Schicht
- 1.6: Gleitschicht
- 1.7: Schutzschicht
- 2: weichmagnetisches Material
- 3: Kabelschutzrohrverbindungsmuffe
- 4: Kabelschutzrohrsystem
- 5: Höchstspannungskabel
- 6: Erdboden
- 6.1: Erdoberfläche
- 7: Graben
- 8: Verfüllmaterial
- 9: Markierungselement
- 10: Stromleitungsanordnung

## Patentansprüche

1. Kabelschutzrohr (1) für die Aufnahme wenigstens eines Höchstspannungskabels (5), das eine Wandung (1.1) aufweist, die ein Polymermaterial enthält, **dadurch gekennzeichnet, dass** in der Wandung (1.1) ein weichmagnetisches Material (2) enthalten ist.

2. Kabelschutzrohr (1) nach Anspruch 1, **dadurch gekennzeichnet, dass** das weichmagnetische Material (2) eine magnetische Permeabilitätszahl µr > 500 aufweist.

3. Kabelschutzrohr (1) nach Anspruch 1 oder 2, **dadurch gekennzeichnet, dass** das weichmagnetische Material (2) Eisen oder eine Eisen-Silizium-Legierung oder eine Eisen-Nickel-Legierung oder ein µ-Metall oder eine Mischung der vorgenannten ist.

4. Kabelschutzrohr (1) nach einem der vorangehenden Ansprüche, **dadurch gekennzeichnet, dass** das weichmagnetische Material (2) als Partikel oder als Filament oder als Draht oder als Band oder als Folie ausgebildet ist.

5. Kabelschutzrohr (1) nach einem der vorangehenden Ansprüche, **dadurch gekennzeichnet, dass** das Polymermaterial ausgewählt ist aus einem Thermoplasten, insbesondere einem Polyolefin, bevorzugt einem Polypropylen (PP) oder einem Polyethylen (PE) oder einem vernetzten Polyethylen (PE-X) oder einem Polybutylen (PB), oder Polyvinylchlorid (PVC), oder einem Copolymer, einem Blend oder einer Mischung der vorgenannten.

6. Kabelschutzrohr (1) nach einem der vorangehenden Ansprüche, **dadurch gekennzeichnet, dass** dessen Wandung (1.1) mehrschichtig aufgebaut ist.

7. Kabelschutzrohr (1) nach Anspruch 6, **dadurch gekennzeichnet, dass** als innerste Schicht der Wandung (1.1) eine Gleitschicht (1.6) und / oder als äußerste Schicht der mehrschichtigen Wandung (1.1) eine Schutzschicht (1.7) angeordnet ist.

8. Kabelschutzrohr (1) nach einem der vorangehenden Ansprüche, **dadurch gekennzeichnet, dass** dieses mit wenigstens einem weiteren Kabelschutzrohr (1') durch eine Kabelschutzrohrverbindungsmuffe (3) verbunden ist.

9. Kabelschutzrohrsystem (4), umfassend wenigstens ein Kabelschutzrohr (1) nach einem der Ansprüche 1 bis 8 und einer mit dem wenigstens einen Kabelschutzrohr (1) verbundenen Kabelschutzrohrverbindungsmuffe (3).

10. Stromleitungsanordnung (10) umfassend wenigstens ein Höchstspannungskabel (5), das in einem Kabelschutzrohr (1) nach einem der Ansprüche 1 bis 8 oder in einem Kabelschutzrohrsystem (4) nach Anspruch 9 aufgenommen ist.
